# EUROPÄISCHE PATENTSCHRIFT

(11) **EP 4 152 029 B1**
(45) Veröffentlichungstag und Bekanntmachung des Hinweises auf die Patenterteilung: **26.03.2025**
(21) Anmeldenummer: 21196826.8
(22) Anmeldetag: 15.09.2021
(51) Int. Cl.: G01R 33/36, G01R 33/565

(54) **VERFAHREN UND VORRICHTUNG ZUM BEREITSTELLEN EINER ANTENNENMATRIX ZUM AUSSENDEN UND/ODER EMPFANGEN VON HOCHFREQUENZSIGNALEN EINER MAGNETRESONANZAUFNAHME**
METHOD AND DEVICE FOR PROVIDING AN ANTENNA MATRIX FOR TRANSMITTING AND / OR RECEIVING HIGH FREQUENCY SIGNALS FROM A MAGNETIC RESONANCE RECORDING
PROCÉDÉ ET DISPOSITIF DE FOURNITURE D'UNE MATRICE D'ANTENNE PERMETTANT D'ÉMETTRE ET/OU DE RECEVOIR DES SIGNAUX HAUTE FRÉQUENCE D'UNE IMAGE PAR RÉSONANCE MAGNÉTIQUE

(43) Veröffentlichungstag der Anmeldung: 22.03.2023
(73) Patentinhaber: Siemens Healthineers AG, 91301 Forchheim (DE); The University Of Queensland, Brisbane, Queensland 4072 (AU)
(72) Erfinder: Jin, Jin, Algester, QLD 4115 (AU); Liu, Feng, Brisbane, 4078 (AU); O'Brien, Kieran, Highgate Hill, 4101 (AU)
(74) Vertreter: Siemens Healthineers Patent Attorneys

(56) Entgegenhaltungen:
- EP-A1- 2 887 087
- US-A1- 2011 006 766
- CAO ZHIPENG ET AL: "Designing parallel transmit head coil arrays based on radiofrequency pulse performance", MAGNETIC RESONANCE IN MEDICINE, vol. 83, no. 6, 13 November 2019 (2019-11-13), US, pages 2331 - 2342, XP055896919, ISSN: 0740-3194, DOI: 10.1002/mrm.28068
- SHUO FENG ET AL: "Coil reduction in parallel excitation with large array", 2010 ANNUAL INTERNATIONAL CONFERENCE OF THE IEEE ENGINEERING IN MEDICINE AND BIOLOGY SOCIETY : (EMBC 2010) ; BUENOS AIRES, ARGENTINA, 31 AUGUST - 4 SEPTEMBER 2010, IEEE, PISCATAWAY, NJ, USA, 31 August 2010 (2010-08-31), pages 3313 - 3316, XP031884045, ISBN: 978-1-4244-4123-5, DOI: 10.1109/IEMBS.2010.5627495

## Beschreibung

Die Erfindung betrifft ein Verfahren zum Bereitstellen einer Antennenmatrix bzw. eines Antennenarrays zum Aussenden von Hochfrequenzpulsen zum Beeinflussen einer Kernspinpräzession in einem Hochfeld-Magnetresonanztomographen und/oder Empfangen von Magnetresonanzsignalen der Kernspinpräzession.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden.

Bei Magnetresonanztomographen mit höheren Magnetfeldern, beispielsweise von 3 Tesla oder größer, insbesondere 7 Tesla, ist wegen der höheren Larmorfrequenz und der damit verbundenen kürzeren Wellenlängen und den daraus resultierenden Interferenzen eine homogene Feldstärke des magnetischen Wechselfeldes und daraus resultierend eine homogene Anregung mit einer Körperspule kaum zu erzielen. Es kommen daher eine Vielzahl von lokalen Sendeantennen mit zumindest teilweise unabhängiger Ansteuerung zur Anwendung.

Diese Antennen können in einer Matrix bzw. einem Array angeordnet sein. Die Matrix weist dabei häufig mehr Antennenelemente als Sendekanäle auf. Welche Antennenelemente anzusteuern sind, ist dabei von einer Vielzahl von Umständen wie Patient und/oder Anordnung der Antennenmatrix abhängig.

Der Artikel von Zhipeng Cao et al, Magn Reson Med 83:2331-2342, 2020 offenbart ein Verfahren zum Design eines Kopfspulen-Arrays für eine parallele Anregung in der MRT.

Es ist daher eine Aufgabe der vorliegenden Erfindung, die Nutzung einer Antennenmatrix mit einer Mehrzahl an Sendekanälen zu vereinfachen und zu verbessern.

Diese Aufgabe wird von einem Verfahren nach Anspruch 1 gelöst.

Das erfindungsgemäße Verfahren ist zum Bereitstellen einer Antennenmatrix für Bilderfassung mittels Magnetresonanztomographie vorgesehen. Die Antennenmatrix kann sowohl zum Aussenden von Hochfrequenzpulsen zum Beeinflussen einer Kernspinpräzession in einem Hochfeld-Magnetresonanztomographen vorgesehen sein, oder auch zum Empfangen von Magnetresonanzsignalen der Kernspinpräzession, die durch diese Hochfrequenzpulse beeinflusst werden. Das Bereitstellen der Antennenmatrix erfolgt erfindungsgemäß in einem Designprozess für die Antennenmatrix. Der Hochfrequenzpuls kann dabei zur Anregung der Kernspinpräzession vorgesehen sein oder auch zur Beeinflussung der Kernspins im Rahmen unterschiedlicher Sequenzen. Die durch das erfindungsgemäße Verfahren ermittelte Antennenmatrix ist hierbei aufgrund der Zeitumkehrbarkeit der elektromagnetischen Ausbreitung sowohl für das Aussenden als auch für den Empfang geeignet.

Das Verfahren weist einen Schritt auf, eine Vielzahl N über ein vorbestimmtes Volumen verteilter unterschiedlicher vorbestimmter Positionen zu bestimmen. Unter verteilt ist dabei zu verstehen, dass jeder Punkt des vorbestimmten Volumens nicht weiter als ein maximaler vorbestimmter Abstand von einer der vorbestimmten Positionen entfernt ist. Der vorbestimmte Abstand kann beispielsweise kleiner als ein vierfaches, dreifaches oder zweifaches der Kubikwurzel des vorbestimmten Volumens sein. Der Abstand kann auch größer als ein Viertel, Drittel oder der Hälfte der Kubikwurzel des vorbestimmten Volumens sein. Mit anderen Worten sind die Positionen über das Volumen im Wesentlichen gleichmäßig verteilt. Das vorbestimmte Volumen kann beispielsweise durch konstruktive Stützelemente vorgegeben sein, wie beispielsweise durch eine Schale oder ein Gerippe einer Lokalspule wie einer Kopfspule, einer Kniespule, eine Spine-Spule oder anderer Lokalspulen, oder auch durch konstruktive Elemente des Magnetresonanztomographen wie Patiententunnel oder Patientenliege. Das vorbestimmte Volumen kann auch während unterschiedlicher Untersuchungen unterschiedlich sein, beispielsweise wenn es durch eine flexible Lokalspule definiert wird. Die flexible Lokalspule kann dabei um den Patienten bzw. Gliedmaßnahmen gelegt bzw. gewickelt werden.

Vorzugsweise befinden sich die Positionen auf einer Oberfläche, die das Volumen einschließt. Als Oberfläche wird in diesem Sinne auch eine Schale bzw. eine Hülle des Volumens angesehen. Dies kann in oder an einer Schale einer starren Lokalspule sein oder im Inneren einer flexiblen Lokalspule, die um den Patienten zur Bilderfassung angeordnet wird. Dabei sind die vorbestimmten Positionen vorzugsweise im Wesentlichen gleichmäßig über die Oberfläche verteilt. Der Abstand der Positionen kann beispielsweise durch ein Intervall beschränkt sein, dessen Obergrenze das Doppelte, Fünffache oder Zehnfache einer Gitterkonstante bei gleichmäßiger Abdeckung mit einem quadratischen Gitter mit N Gitterpunkten ist und die Untergrenze eine Hälfte, Fünftel oder Zehntel der Gitterkonstante.

Es ist aber auch denkbar, dass die Positionen in der Tiefe gestaffelt sind, d.h. mit unterschiedlichem Abstand zu einer zu erfassenden Region in gleicher Richtung angeordnet sind. Denkbar ist dies beispielsweise, wenn eine flexible Lokalspule überlappend um den Patienten angeordnet ist. Möglich ist aber auch eine Lokalspule, bei der die Positionen in einer Mehrzahl an Schalen bzw. einem Gitter mit unterschiedlichem Abstand zu einer zu erfassenden Region angeordnet sind, um unterschiedliche Phasenlagen bereitzustellen.

Erfindungsgemäß ist das erfindungsgemäße Verfahren Teil eines Designprozesses für eine Lokalspule und das Volumen ist ein virtuelles Volumen. Das vorbestimmte Volumen kann beispielsweise das maximal durch die Lokalspule bzw. Antennenmatrix einzunehmende Volumen umfassen. Innerhalb des vorbestimmten Volumens können die Positionen ein virtuelles Gitter innerhalb des Volumens bilden, beispielsweise ein kubisches, hexagonale oder auch radialsymmetrisches Gitter. Vorzugsweise sind von den vorbestimmten Positionen Gitterpunkte ausgenommen, die bei einer anwendungsgemäßen Lage der Antennenmatrix bzw. Lokalspule von dem Patienten bzw. Untersuchungsobjekt eingenommen werden.

Die Abstände der Positionen untereinander sind dabei vorzugsweise größer als 1%, 5%, 10%, 25% oder 50% einer von der Antennenmatrix auszusendenden bzw. zu empfangenden Wellenlänge. Die Wellenlänge ist dabei durch die Wellenlänge eines Radiosignals in der Luft bei einer Frequenz, die durch die Larmorfrequenz der Kernspinpräzession bei dem statischen Magnetfeld B0 des Magnetresonanztomographen gegeben ist.

In einem Schritt des Verfahrens wird eine Verteilung von einer Mehrzahl an Antennenelementen über die vorbestimmten Positionen bestimmt. Dabei ist die Mehrzahl der Antennen kleiner oder gleich der Anzahl der Positionen. Vorzugsweise ist die Mehrzahl der Antennen größer als eine Anzahl an verfügbaren Sende- bzw. Empfangskanälen.

Bei einem Designprozess kann im einfachsten Fall jede vorbestimmte Position mit einem Antennenelement besetzt sein.

Bei einer veränderlichen Lokalspule wie einer flexiblen Lokalspule hingegen ist die Verteilung vorzugsweise durch die Anordnung der Antennenelemente innerhalb der flexiblen Lokalspule und die Anordnung der flexiblen Lokalspule am Untersuchungsobjekt bestimmt.

In einem Schritt des erfindungsgemäßen Verfahrens wird ein Hochfrequenzpuls oder ein Hochfrequenzpuls und ein Gradientenpuls zu einer Beeinflussung der Kernspins in dem Magnetresonanztomographen unter Aussendung des Hochfrequenzpulses über die Verteilung von Antennenelementen durch Lösen eines Optimierungsproblems ermittelt. Der Hochfrequenzpuls kann beispielsweise ein Anregungspuls für die Kernspins sein oder ein Puls, um die Kernspins zu "flippen". Der Gradientenpuls kann dabei ein vorbestimmter Gradientenpuls sein, z.B. zur Schichtkodierung. Beispielsweise kann die Randbedingung ein vorbestimmter zu erzielender Flip-Winkel der abzubildenden Kernspins im B0-Magnetfeld sein. Durch eine Bloch-Simulation der erzielten Flip-Winkel können in einem linearen Optimierungsverfahren zunächst die Flip-Winkel bestimmt und dann durch eine Least-Square-Root-Verfahren die Verteilung der Sendefeldstärken der einzelnen Antennenelemente auf eine möglichst kleine Variation optimiert werden. Eine andere Randbedingung könnte beispielsweise eine maximale SAR-Belastung sein. Das Ermitteln des optimierten Hochfrequenzpulses kann durch die Steuerung des Magnetresonanztomographen oder durch einen anderen dedizierten Prozessor erfolgen. Randbedingungen und zu optimierende Parameter sind auch nachfolgend zu den Unteransprüchen angegeben.

In einem weiteren Schritt des Verfahrens wird die Verteilung der vorbestimmten Positionen reduziert. Dazu werden aus den vorbestimmten Positionen, die zuvor bei der Ermittlung des optimierten Hochfrequenzpulses berücksichtigt wurden, eine oder mehrere Positionen in Abhängigkeit von dem ermittelten Hochfrequenzpuls gestrichen, d.h. in nachfolgenden Schritten nicht mehr berücksichtigt. Insbesondere ist es denkbar, dass das Verfahren iterativ angewendet wird und die gestrichenen Positionen nicht mehr bei der Ermittlung des Hochfrequenzpulses berücksichtigt wird, sondern nur noch die verbleibenden Positionen.

Der Hochfrequenzpuls weist vorzugsweise für jede Positionen eine Komponente auf, ist also mehrdimensional. Vorzugsweise weist jede Komponente eine Amplitude und/oder Leistung auf, die bei der Ermittlung als eine Amplitude oder Leistung eines an dieser Position angeordnetem Antennenelement zugeführt wird. Es kann sich dabei auch um eine davon abhängige Größe handeln. Es ist dabei auch denkbar, dass das Antennenelement nur virtuell ist, also lediglich beim Ermitteln des Hochfrequenzpulses an der vorbestimmten Position in einer Berechnung berücksichtigt wird.

Das Reduzieren bzw. Streichen erfolgt dabei in Abhängigkeit von dem ermittelten Hochfrequenzpuls. Vorzugsweise ist das Reduzieren von einer Komponente des Hochfrequenzpulses abhängig, die der Position bzw. einem an dieser Position angeordneten Antennenelement zugeordnet ist. Vorzugsweise werden dabei Positionen reduziert, deren Beitrag zu dem Hochfrequenz-puls gering ist, beispielsweise in dem die zugeführte Leistung des ermittelten Hochfrequenzpulses. Es aber auch denkbar, dass beim Reduzieren der ermittelte Hochfrequenzpuls in weiterem Sinne berücksichtigt wird, insbesondere nicht nur lokal durch eine der zu streichenden Position zugeordneten Komponente. Es ist beispielsweise auch denkbar, wie nachfolgend zu den Unteransprüchen erläutert, dass Komponenten des ermittelten Hochfrequenzpulses für Positionen berücksichtigt werden, die benachbart zu der zu reduzierenden Position sind.

In einem weiteren Schritt des erfindungsgemäßen Verfahrens wird ein Abbruchkriterium überprüft, beispielsweise durch die Steuerung des Magnetresonanztomographen oder den dedizierten Prozessor erfolgen. Das Abbruchkriterium kann beispielsweise eine Eigenschaft eines von dem ermittelten Hochfrequenzpuls mit an den verbleibenden, nicht gestrichenen Positionen angeordneten Antennenelementen von dem Hochfrequenzpuls erzeugten magnetischen und/oder elektrischen Hochfrequenzfeldes sein.

Es kann aber auch, wie nachfolgend zu den Unteransprüchen erläutert, von der Anzahl der verbleibenden Positionen oder der Geometrie dieser Positionen abhängen.

Wird das Abbruchkriterium nicht erfüllt, wird das Verfahren mit dem Ermitteln des unter einer Randbedingung in einem Optimierungsverfahren ermittelten Hochfrequenzpulses mit der durch das Streichen reduzierten Anzahl an Positionen fortgesetzt.

Wird das Abbruchkriterium erfüllt, wird in einem weiteren Schritt die Antennenmatrix mit Antennenelementen entsprechend der Verteilung über das vorbestimmte Volumen verteilten Positionen bereitgestellt.

Erfindungsgemäß erfolgt dies, indem eine Lokalspule mit einer entsprechenden Antennenmatrix gefertigt wird, wobei in einer Fertigung die ermittelten, nicht gestrichenen Positionen mit Antennenelementen besetzt werden.

Es ist aber in einer nicht durch die Ansprüche umfassten Variante auch denkbar, dass bei einer konfigurierbaren Antennenmatrix die Steuerung des Magnetresonanztomographen die Antennenelemente an den nicht gestrichenen bzw. verbleibenden Positionen bereitstellt, in dem diese durch eine Einstellung aktiviert werden, z.B. durch eine Schaltmatrix mit Empfängern und/oder Sendern bzw. Empfängerkanälen und/oder Sendekanälen verbunden werden, um Signale auszusenden und/oder zu empfangen.

Auf vorteilhafte Weise erlaubt das erfindungsgemäße Verfahren eine Antennenmatrix an unterschiedliche Randbedingungen anzupassen und gleichzeitig die Anzahl der erforderlichen Sende- bzw. Empfangskanäle zu reduzieren.

Weitere vorteilhafte Ausführungsformen sind in den nachfolgenden Unteransprüchen angegeben.

In einer bevorzugten Ausführungsform des erfindungsgemäßen Verfahrens wird der ermittelte Hochfrequenzpuls im Rahmen einer Bilderfassung mit dem Magnetresonanztomographen über die bereitgestellte Antennenmatrix ausgesendet.

In einer möglichen Ausführungsform des erfindungsgemäßen Verfahrens weist das Verfahren weiterhin den Schritt auf, mit der bereitgestellten Antennenmatrix ein Magnetresonanzsignal zu empfangen.

Durch die Optimierung unter einer Randbedingung wird auf vorteilhafte Weise mit einer begrenzten Anzahl an Sende- und/oder Empfangskanälen eine verbesserte Bildgebung erzielt.

In einer denkbaren Ausführungsform des erfindungsgemäßen Verfahrens sind die Antennenelemente elektrische und/oder magnetische Antennenelemente. Dies können beispielsweise elektrische Monopole, Dipole, Streifenleiter oder magnetische Antennenspulen sein.

Auf vorteilhafte Weise kann das erfindungsgemäße Verfahren Antennenmatrizen für unterschiedliche Frequenzbereiche bereitstellen.

In einer möglichen Ausführungsform des erfindungsgemäßen Verfahrens ist das zu lösende Optimierungsproblem eine zu erzielende vorbestimmte Stärke oder eine vorbestimmte Homogenität des magnetischen Wechselfeldes B1 in einem vorbestimmten Zielvolumen. Beispielsweise kann eine Mindestanforderung eine zu erreichende Homogenität der Anregung der Kernspins durch das magnetische B1-Wechselfeld sein oder eine nicht zu überschreitende Feldstärke.

Durch den zu optimierenden Parameter können z.B. mit einer optimierten Homogenität auf vorteilhafte Weise Abschattungen im Bild reduziert werden oder die Sicherheit des Patienten durch zuverlässiges Einhalten von Grenzwerten verbessert werden.

In einer möglichen Ausführungsform des erfindungsgemäßen Verfahrens ist die Randbedingung im Optimierungsverfahren eine maximal zulässige Kopplung benachbarter Antennenelemente. Denkbar ist auch ein minimal nicht zu unterschreitender Abstand zwischen zwei Antennenelementen. Es kann auch ein nicht zu überschreitender Grenzwert für einen Strom oder Spannung des Hochfrequenzpulses durch ein Antennenelement sein. Möglich ist auch ein nicht zu überschreitender Grenzwert für eine Feldstärke oder Leistungsdichte des durch den Hochfrequenzpuls mit der bereitgestellten Antennenmatrix sein.

Auf vorteilhafte Weise verbessert eine geringere Kopplung die zu erzielenden Abbildungen, während durch die eingehaltenen Grenzwerte die Sicherheit im Betrieb des Magnetresonanztomographen gesteigert wird.

In einer denkbaren Ausführungsform des erfindungsgemäßen Verfahrens erfolgt in dem Schritt des Reduzierens das Reduzieren bzw. Streichen der Antennenelemente in Abhängigkeit von einer durch den Hochfrequenzpuls dem jeweiligen Antennenelement zugeordneten Spannung, Stromstärke oder Hochfrequenzleistung. Beispielsweise können die Antennenelemente mit den geringsten zugeordneten Spannungen, Strömen und/oder Hochfrequenzleistungen gestrichen werden.

Auf vorteilhafte Weise können durch die Berücksichtigung der Spannung, Ströme bzw. Hochfrequenzleistung die Antennenelemente identifiziert und gestrichen werden, die einen geringen Beitrag zu dem ermittelten magnetischen Wechselfeld B1 beitragen. Dies gilt aufgrund der Umkehrbarkeit der Maxwellschen Gesetze in gleicher Weise für den Empfangsfall, bei dem die Antennenelemente mit dem geringsten Beitrag beim Senden auch den geringsten Anteil an einem Empfangssignal erbringen.

In einer möglichen Ausführungsform des erfindungsgemäßen Verfahrens ist die Abhängigkeit von der Spannung, Strom oder Hochfrequenzleistung ein nicht zu unterschreitender Leistungsschwellwert. Dies kann beispielsweise eine minimale Leistung sein, die über das jeweilige Antennenelement abgestrahlt wird. Der Schwellwert kann beispielsweise kleiner 1 W, 5 W oder 10 W sein.

Der Schwellwert erlaubt eine effiziente Aussortierung von Positionen, die zur Erzeugung des magnetischen Wechselfeldes von geringer Bedeutung sind.

In einer denkbaren Ausführungsform des erfindungsgemäßen Verfahrens wird in dem Schritt des Reduzierens dieser von einer durch den ermittelten Hochfrequenzpuls zugeordnetem Strom, Spannung oder Hochfrequenzleistung eines benachbarten Antennenelements während des vorbestimmten Hochfrequenzpulses abhängig gemacht. Als benachbartes Antennenelement wird dabei beispielsweise ein reales Antennenelement oder eine Position für ein virtuelles Antennenelement angesehen, das an einer Position angeordnet ist, die benachbart zu der Position ist, für die eine Entscheidung über eine Besetzung oder Aktivierung zu treffen ist. Benachbart kann dabei ein Element mit dem geringsten Abstand sein, oder in einem Gitter oder einer Matrix auf benachbarten Kotenpunkten. Denkbar ist auch, dass übernächste Nachbarn als benachbart im Sinne der Erfindung angesehen werden. Ein virtuelles Antennenelement ist dabei denkbar, wenn bei der Bereitstellung bzw. Konstruktion einer Lokalspulenmatrix lediglich eine Simulation für mögliche Positionen erfolgt. Denkbar ist aber auch, dass bei einer realen Antenne, beispielsweise bei einer flexiblen Lokalspule bzw. Antennenmatrix durch die Anordnung am Patienten jeweils benachbarte Positionen bzw. Antennenelemente entstehen, indem die Matrix durch Wickeln überlappt.

Durch die Berücksichtigung der in dem Hochfrequenzpuls dem benachbarten Antennenelement zugeordneten Ströme, Spannungen und/oder Hochfrequenzleistung benachbarter Positionen bzw. Antennenelemente können auf vorteilhafte Weise Redundanzen erkannt und beseitigt werden.

In einer möglichen Ausführungsform des erfindungsgemäßen Verfahrens betrifft das Abbruchkriterium eine maximale Anzahl an Antennenelementen. Vorzugsweise soll eine maximale Anzahl an aktiven Antennenelementen nicht überschritten werden. Diese Anzahl kann beispielsweise durch die maximale Anzahl an gleichzeitig verfügbaren Anschlusskontakten oder voneinander unabhängigen Sendekanälen vorgegeben sein.

Das erfindungsgemäße Verfahren erlaubt so eine effektive Optimierung der Konfiguration für unterschiedliche Magnetresonanzsysteme und/oder Anordnungen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines Magnetresonanztomographen, der nicht in den Schutzumfang der Ansprüche fällt;
- Fig. 2: eine schematische Darstellung von Teilen des Magnetresonanztomographen im Detail;
- Fig. 3: ein schematisches Ablaufdiagramm für ein beispielhaftes erfindungsgemäßes Verfahren.

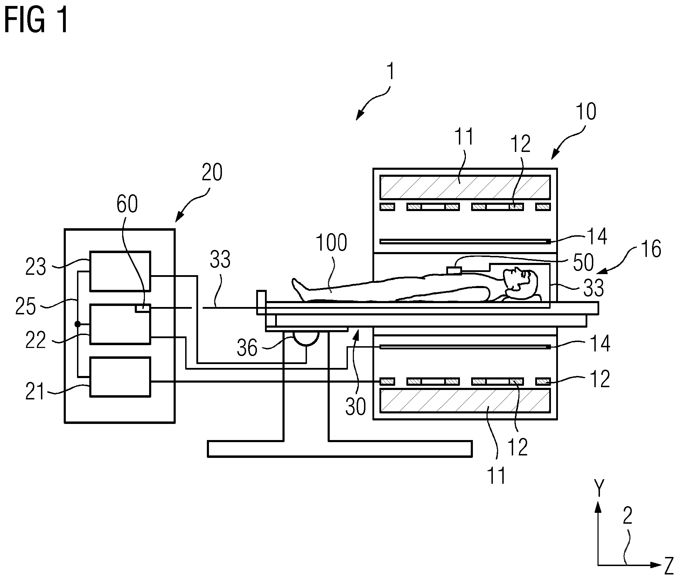

Fig. 1 zeigt eine schematische Darstellung einer Ausführungsform eines Magnetresonanztomographen 1.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Magnetfeldstärken können jedoch auch Permanentmagnete oder Elektromagnete mit normalleitenden Spulen Verwendung finden. Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 zeitlich und räumlich variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungssignale können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist eine Lokalspule 50 angeordnet, die ein Magnetresonanzsignal aus dem Körper des Patienten 100 aufnimmt und über eine Signalverbindung 33 an Empfänger der Hochfrequenzeinheit 22 weiterleitet.

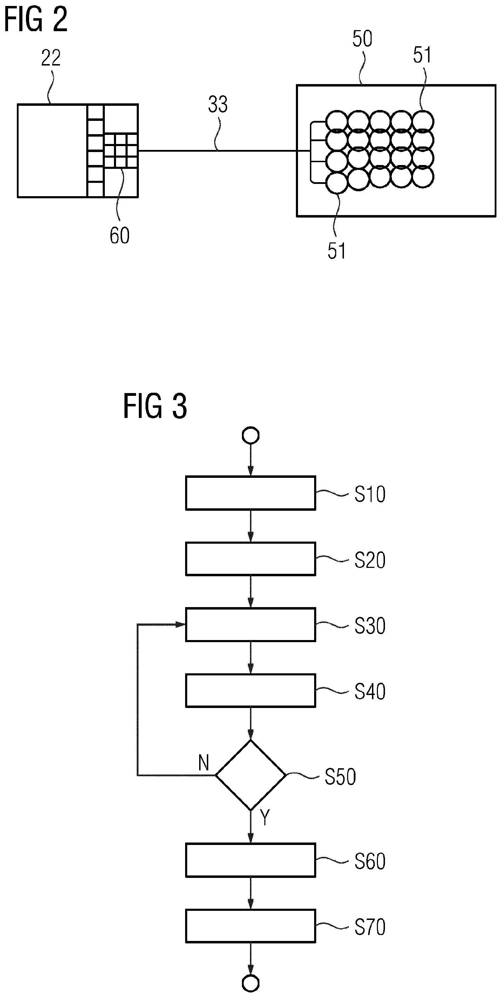

In Fig. 2 sind Teile des Magnetresonanztomographen im Detail schematisch dargestellt.

Die Lokalspule 50 weist eine Vielzahl von Antennenspulen 51 als Antennenelemente auf, die als Matrix über die Lokalspule 50 verteilt sind, um eine Oberfläche des Patienten 100 für das Anregen bzw. Beeinflussen von Kernspins durch Hochfrequenzpulse und/oder den Empfang eines MR-Signals aus dem Patienten 100 abzudecken. Die Lokalspule 50 kann dabei beispielsweise eine flexible Lokalspule sein, die um den Patienten oder seine Gliedmaßen gewickelt wird, sodass die relative Anordnung der Antennenspulen 51 zueinander bei jeder Bilderfassung variieren kann, beispielsweise indem Lagen der flexiblen Lokalspule überdecken.

Aufgrund dieser flexiblen Konfiguration weist der Magnetresonanztomograph 1 in einer möglichen Ausführungsform eine Schaltmatrix 60 auf, die ausgelegt ist, Antennenspulen 51 mit Sendern und/oder Empfängern der Hochfrequenzeinheit 22 zu verbinden. Vorzugsweise weist die Schaltmatrix 60 dabei mehr Anschlüsse für Antennenspulen 51 als Anschlüsse für Sender bzw. Empfänger auf, sodass eine Auswahl der Antennenspulen 51 mit einem Sender bzw. Empfänger verbunden werden kann. Die Auswahl wird dabei vorzugsweise von der Steuerung nach dem nachfolgend zu Fig. 3 beschriebenen erfindungsgemäßen Verfahren getroffen. Die Steuerung 23 stellt dann über die Schaltmatrix 60, z.B. mittels eines Einstellkommandos, die Verbindung gemäß der getroffenen Auswahl her. Es ist dabei denkbar, dass die Schaltmatrix 60 wie in Fig. 2 dargestellt, in der Hochfrequenzeinheit 22 angeordnet ist. Die Schaltmatrix 60 kann aber auch in der Lokalspule 50 angeordnet sein, sodass nur noch für die Anschlüsse zu Sendern bzw. Empfängern eine Verbindung in der Signalverbindung 33 bereitgestellt werden muss. So kann auf vorteilhafte die Anzahl der notwendigen Verbindungen zwischen Lokalspule 50 und Hochfrequenzeinheit 22 reduziert werden. Das gilt sowohl für drahtgebundene Kabel, bei denen die Dicke des Kabels und die Anzahl der Kontakte verringert werden kann, aber auch für drahtlose Signalverbindungen 33, um die Bandbreite zu reduzieren.

Es ist in einer Ausführungsform denkbar, dass die Anordnung der Antennenspulen 51 in einer Lokalspule 50 nicht im Betrieb zwischen den Bilderfassungen veränderlich ist, sondern z.B. durch eine starre Struktur der Lokalspule 50 festgelegt sind.

In dieser Ausführungsform ist es denkbar, dass das erfindungsgemäße Verfahren der Fig. 3 bereits beim Design der Lokalspule 50 ausgeführt wird und gemäß der mit dem erfindungsgemäßen Verfahren ermittelten Auswahl die Verteilung der Antennenelemente bzw. Antennenspulen 51 über die möglichen Positionen erfolgt. Die Fertigung der Lokalspule 50 kann dann gemäß dieser Verteilung erfolgen, sodass nur die in dem erfindungsgemäßen Verfahren ermittelte Anzahl an Antennenelementen an den vorbestimmten Positionen angeordnet wird.

In Fig. 3 ist ein Ablaufplan einer Ausführungsform des erfindungsgemäßen Verfahrens schematisch dargestellt. Mittels des erfindungsgemäßen Verfahrens wird eine Antennenmatrix ermittelt und bereitgestellt. Die bereitgestellte Antennenmatrix ist ausgelegt, Hochfrequenzpulsen zum Beeinflussen einer Kernspinpräzession in einem Hochfeld-Magnetresonanztomographen auszusenden und/oder Magnetresonanzsignalen der Kernspinpräzession zu empfangen. Dabei genügen die Sende- bzw. Empfangseigenschaften einem vorbestimmten Kriterium bzw. einer vorbestimmten Randbedingung. Die Randbedingung kann beispielsweise die Homogenität des erzeugten B1-Feldes betreffen oder Grenzwerte für nicht zu überschreitende Feldstärken oder Hochfrequenzleistungen.

In einem Schritt S10 wird eine Vielzahl N an über ein vorbestimmtes Volumen verteilten unterschiedlichen vorbestimmten Positionen bestimmt. Die Positionen können beispielsweise durch Knotenpunkte eines virtuellen Gitters gegeben sein, das in ein mögliches Volumen der Lokalspule einbeschrieben ist.

In einem Schritt S20 wird eine Verteilung von einer Mehrzahl an Antennenelementen über die vorbestimmten Positionen ermittelt. Im einfachsten Fall kann es vorgesehen sein, dass jeder Position ein Antennenelement zugeordnet wird. Dies kann beispielsweise bei einer flexiblen Lokalspule der Fall sein. Denkbar ist aber auch, dass mittels geometrischer Überlegungen bestimmte Positionen bereits ausgeschlossen werden können, beispielsweise, weil der Abstand bei anwendungsgemäßer Anordnung einen Schwellwert unterschreitet. Denkbar ist auch, dass eine Kopplung von Antennenspulen 51 mittels eines Testsignals gemessen wird und Antennenspulen aus der Verteilung gestrichen werden, deren Kopplung zu ihrem jeweiligen Nachbarn einen Schwellwert überschreitet.

In einem Schritt S30 wird ein Hochfrequenzpuls ermittelt, der auf eine Randbedingung optimiert ist, wenn er über die Verteilung von Antennenelementen zur Beeinflussung der Kernspins ausgesendet wird. Der Hochfrequenzpuls kann beispielsweise ein Puls sein, um die Kernspins zu einer Präzession anzuregen. Es sind auch Hochfrequenzpulse denkbar, die eine gezielte Änderung des Auslenkungswinkels bewirken sollen, wie ein Flipwinkel um 180, um z.B. in einer Echospinsequenz die Phasen wieder zu fokussieren. Die Randbedingung kann beispielsweise eine maximale Homogenität des erzeugten magnetischen Wechselfeldes bzw. der Anregung der Kernspins sein. Denkbar ist auch ein nicht zu überschreitender Maximalwert oder Minimalwert oder eine Gesamtleistung des Hochfrequenzpulses. Wegen der Umkehrbarkeit der zugrundeliegenden Maxwellschen Gesetze entspricht dabei eine Randbedingung für das Senden auch jeweils einer Randbedingung für den Empfangsfall. So ist beispielsweise eine homogene Anregung entsprechend einer homogenen Empfindlichkeit.

Das Ermitteln des Hochfrequenzpulses in S30 erfolgt vorzugsweise mit der Steuerung 23 des Magnetresonanztomographen 1, beispielsweise mit einem Optimierungsverfahren wie LSR. Es ist aber bei der erfindungsgemäßen Konstruktion bzw. Design einer Antennenmatrix auch die Ausführung auf einem dedizierten Rechner denkbar. Die Antennenelemente sind dann bis zur Implementierung virtuelle Antennenelemente in dem Optimierungsverfahren. In einem Schritt S40 werden ein oder mehrere Antennenelemente der Verteilung in Abhängigkeit von dem ermittelten Hochfrequenzpuls aus der Verteilung gestrichen bzw. die Verteilung dadurch reduziert. Denkbar ist es beispielsweise, dass das oder die Antennenelemente mit der niedrigsten abgestrahlten Leistung bei dem ermittelten Hochfrequenzpuls gestrichen wird bzw. werden, da der Beitrag am Feld am geringsten ist.

Es ist auch möglich, dass ein unterer oder oberer Leistungsschwellwert für die Leistung des Hochfrequenzpulses eines jeweiligen Antennenelements festgelegt ist, bei dessen über- oder unterschreiten das jeweilige Antennenelement in der Verteilung gestrichen wird.

Es ist auch denkbar, dass bei dem Streichen die Werte des Hochfrequenzpulses neben den ermittelten Werten für das jeweilige Antennenelement auch Werte für benachbarte Antennenelemente berücksichtigt werden. Denkbar ist es beispielsweise, dass die ermittelte Leistung eines Antennenelements die ermittelte Leistung eines benachbarten Antennenelements um einen gewissen Faktor unterschreitet, beispielsweise um 12 dB, 18 dB, 24 dB oder mehr. Bei wesentlich stärker emittierenden bzw. empfangenden Antennenelementen in der Nachbarschaft kann das dazwischenliegende Antennenelement auf vorteilhafte Weise weggelassen werden bzw. nicht aktiv sein.

In einem weiteren Schritt S50 überprüft die Steuerung 23 bzw. der Rechner, ob ein Abbruchkriterium erfüllt ist. Wenn das Abbruchkriterium erfüllt ist, wird das Verfahren mit den nachfolgenden Schritten beendet. Wenn das Abbruchkriterium nicht erfüllt ist, wird mit der geänderten Verteilung ein neuer Hochfrequenzpuls unter der Randbedingung in Schritt S30 ermittelt.

Ein Abbruchkriterium kann beispielsweise sein, wenn die Anzahl der verbleibenden Antennenelemente bzw. Positionen in der Verteilung einen Schwellwert unterschreitet. Dieser Schwellwert kann beispielsweise durch die Anzahl der verfügbaren Sendekanäle oder Empfangskanäle des Magnetresonanztomographen 1 vorgegeben sein. Denkbar ist auch ein Homogenitätskriterium wie eine maximale Abweichung in einer Anregung der Kernspins oder der Feldstärke.

In einem anderen Schritt S60 wird eine Antennenmatrix mit Antennenelementen entsprechend der Verteilung über das vorbestimmte Volumen verteilten Positionen bereitgestellt.

Zum Bereitstellen der Antennenmatrix ist es auch denkbar, dass Abstandshalter z.B. in Form von Polstern oder Schaumstoffstücken etc. an der Antennenmatrix angeordnet werden, um die vorbestimmte Position der Verteilung bereitzustellen.

Erfindungsgemäß wird das Verfahren in der Konstruktion bzw. dem Design einer Antennenmatrix verwendet und das Bereitstellen der Antennenmatrix umfasst den Schritt, Antennenelemente in einer Lokalspule gemäß der bestimmten Verteilung anzuordnen.

In einer möglichen Ausführungsform des erfindungsgemäßen Verfahrens wird weiterhin in einem Schritt S70 der ermittelte Hochfrequenzpuls von dem Magnetresonanztomographen 1 über die Antennenmatrix ausgesendet und/oder in einem Schritt S80 ein Magnetresonanzsignal mit der Antennenmatrix empfangen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, der durch die Ansprüche definiert wird.

## Patentansprüche

1. Verfahren zum Bereitstellen einer Antennenmatrix zum Aussenden von Hochfrequenzpulsen zum Beeinflussen einer Kernspinpräzession in einem Hochfeld-Magnetresonanztomographen und/oder Empfangen von Magnetresonanzsignalen der Kernspinpräzession, wobei das Bereitstellen in einem Designprozess für die Antennenmatrix erfolgt, wobei das Verfahren die Schritte aufweist:
(S10) Bestimmen einer Vielzahl N an über ein vorbestimmtes Volumen verteilten unterschiedlichen vorbestimmten Positionen;
(S20) Bestimmen einer Verteilung von einer Mehrzahl an Antennenelementen über die vorbestimmten Positionen;
(S30) Ermitteln eines Hochfrequenzpulses oder
Hochfrequenzpulses und Gradientenpulses zur Beeinflussung der Kernspinpräzession durch Aussendung des Hochfrequenzpulses über die Verteilung von Antennenelementen, wobei der Hochfrequenzpuls mittels Lösen eines Optimierungsproblems unter einer Randbedingung ermittelt wird;
(S40) Reduzieren der Verteilung durch Streichen eines Antennenelements in Abhängigkeit von dem ermittelten Hochfrequenzpuls;
(S50) Überprüfen eines Abbruchkriteriums und Fortsetzen mit dem Schritt des Ermittelns eines Hochfrequenzpulses (S30), wenn das Abbruchkriterium nicht erfüllt ist;
(S60) Bereitstellen der Antennenmatrix mit Antennenelementen entsprechend der Verteilung über das vorbestimmte Volumen verteilten Positionen,
**dadurch gekennzeichnet, dass**
eine Lokalspule mit einer entsprechenden Antennenmatrix gefertigt wird, wobei in einer Fertigung die ermittelten,
nicht gestrichenen Positionen mit Antennenelementen besetzt werden.

2. Verfahren nach Anspruch 1, wobei das Verfahren weiterhin den Schritt (S70) des Aussendens des Hochfrequenzpulses und/oder den Schritt (S80) des Empfangens eines Magnetresonanzsignals aufweist.

3. Verfahren nach Anspruch 1 oder 2, wobei die Antennenelemente elektrische und/oder magnetische Antennenelemente sind.

4. Verfahren nach einem der Ansprüche 1 bis 3, wobei ein Ziel des Optimierungsproblems wenigstens eines aus magnetischer und/oder elektrische Feldstärke in einem vorbestimmten Aufnahmebereich, Homogenität der magnetischen und/oder elektrischen Feldstärke in dem vorbestimmten Aufnahmebereich, eine vorbestimmte Verteilung der magnetischen und/oder elektrischen Felder unter einer Mehrzahl der Antennenelemente ist.

5. Verfahren nach einem der Ansprüche 1 bis 4, wobei die Randbedingung eines aus maximal zulässiger Kopplung oder minimaler wechselseitiger Abstand zweier Antennenelemente, ein Leistungs- oder Stromgrenzwert für ein Antennenelement oder ein SAR Grenzwert ist.

6. Verfahren nach einem der vorhergehenden Ansprüche, wobei in dem Schritt des Reduzierens (S40) das Reduzieren der Antennenelemente in Abhängigkeit von einer durch den Hochfrequenzpuls dem jeweiligen Antennenelement zugeordneten Hochfrequenzleistung und/oder elektrischen Spannung und/oder elektrischem Strom erfolgt.

7. Verfahren nach Anspruch 6, wobei die Abhängigkeit von der Hochfrequenzleistung und/oder elektrischen Spannung und/oder elektrischem Strom ein nicht zu unterschreitender Grenzwert ist.

8. Verfahren nach Anspruch 6, wobei der Schritt (S40) des Reduzierens von einer einem benachbarten Antennenelement durch den vorbestimmten Hochfrequenzpulses zugeordneten Hochfrequenzleistung und/oder elektrischen Spannung und/oder elektrischem Strom abhängt.

9. Verfahren nach einem der vorhergehenden Ansprüche, wobei das Abbruchkriterium eine maximale Anzahl an Antennenelementen betrifft.

10. Verfahren nach Anspruch 1, wobei der Schritt (S60) des Bereitstellens der Antennenmatrix mit Antennenelementen entsprechend der Verteilung über das vorbestimmte Volumen verteilten Positionen den Schritt aufweist, Abstandshalter zwischen dem Patienten und dem Antennenelement gemäß der Verteilung zu positionieren.

## Claims

1. Method for providing an antenna matrix for transmitting high frequency pulses for influencing a nuclear spin precession in a high-field magnetic resonance tomography system and/or receiving magnetic resonance signals of the nuclear spin precession, wherein the provision takes place in a design process for the antenna matrix,
wherein the method
has the following steps:
(S10) Determining a plurality N of different predetermined positions distributed over a predetermined volume;
(S20) Determining a distribution of a plurality of antenna elements over the predetermined positions;
(S30) Ascertaining a high frequency pulse or high frequency pulses and gradient pulses for influencing the nuclear spin precession by transmitting the high frequency pulse over the distribution of antenna elements, wherein the high frequency pulse is ascertained by means of solving an optimisation problem under a boundary condition;
(S40) Reducing the distribution by eliminating an antenna element as a function of the ascertained high frequency pulse;
(S50) Checking an abort criterion and continuing with the step of ascertaining a high frequency pulse (S30), if the abort criterion is not fulfilled;
(S60) Providing the antenna matrix with antenna elements according to the distribution of positions distributed over the predetermined volume,
**characterised in that**
a local coil is manufactured with a corresponding antenna matrix, wherein the determined not-eliminated positions are populated with antenna elements during manufacture.

2. Method according to claim 1, wherein the method further has the step (S70) of transmitting the high frequency pulse and/or the step (S80) of receiving a magnetic resonance signal.

3. Method according to claim 1 or 2, wherein the antenna elements are electrical and/or magnetic antenna elements.

4. Method according to one of claims 1 to 3, wherein one objective of the optimisation problem is at least one of a magnetic and/or electrical field strength in a predetermined recording area, homogeneity of the magnetic and/or electrical field strength in the predetermined recording area, a predetermined distribution of the magnetic and/or electrical fields from a plurality of antenna elements.

5. Method according to one of claims 1 to 4, wherein the boundary condition is one of a maximum permissible coupling or minimal alternate distance between two antenna elements, a power or flow limit value for an antenna element or a SAR limit value.

6. Method according to one of the preceding claims, wherein in the reduction step (S40), the reduction in the antenna elements takes place as a function of a high frequency power and/or electrical voltage and/or electrical current assigned to the respective antenna element by the high frequency pulse.

7. Method according to claim 6, wherein the dependency on the high frequency power and/or electrical voltage and/or electrical current is a limit value not to be undercut.

8. Method according to claim 6, wherein the reduction step (S40) depends on a high frequency power and/or electrical voltage and/or electrical current assigned to an adjacent antenna element by the predetermined high frequency pulse.

9. Method according to one of the preceding claims, wherein the abort criterion relates to a maximum number of antenna elements.

10. Method according to claim 1, wherein the step (S60) of providing the antenna matrix with antenna elements according to the distribution of positions distributed over the predetermined volume has the step of positioning spacers between the patient and the antenna element in accordance with the distribution.

## Revendications

1. Procédé de mise en œuvre d'une matrice d'antennes pour l'émission d'impulsions à haute fréquence pour influencer une précession de spins nucléaires dans un tomodensitomètre par résonance magnétique à champ élevé et/ou pour la réception de signaux de résonance magnétique de la précession de spins nucléaires, la mise en œuvre s'effectuant dans un processus de conception de la matrice d'antennes, le procédé comprenant les stades dans lesquels :
(S10) on détermine une pluralité N de positions prédéterminées différentes réparties sur un volume prédéterminé ;
(S20) on détermine une répartition d'une pluralité d'éléments d'antenne sur les positions prédéterminées ;
(S30) on détermine une impulsion à haute fréquence ou une impulsion à haute fréquence et une impulsion de gradient pour influencer la précession de spin nucléaire en émettant l'impulsion à haute fréquence par la répartition d'éléments d'antenne, dans lequel l'impulsion à haute fréquence est déterminée en résolvant un problème d'optimisation dans des conditions aux limites ;
(S40) on réduit la répartition en supprimant un élément d'antenne en fonction de l'impulsion à haute fréquence déterminée ;
(S50) on vérifie un critère d'arrêt et on continue avec le stade (S30) de détermination d'une impulsion à haute fréquence si le critère d'arrêt n'est pas satisfait ;
(S60) on met en œuvre la matrice d'antennes ayant des éléments d'antenne correspondant à la répartition par des positions réparties sur le volume prédéterminé,
**caractérisé en ce que**
on fabrique une bobine locale ayant une matrice d'antenne correspondante, dans laquelle, dans une fabrication, on occupe par des éléments d'antenne les positions déterminées non supprimées.

2. Procédé suivant la revendication 1, le procédé comprenant, en outre, le stade (S70) d'émission de l'impulsion à haute fréquence et/ou le stade (S80) de la réception d'un signal de résonance magnétique.

3. Procédé suivant la revendication 1 ou 2, dans lequel les éléments d'antenne sont des éléments d'antenne électriques et/ou magnétiques.

4. Procédé suivant l'une des revendications 1 à 3, dans lequel un objectif du problème d'optimisation est au moins l'un parmi l'intensité du champ magnétique et/ou électrique dans une zone de réception déterminée à l'avance, l'homogénéité de l'intensité du champ magnétique et/ou électrique dans la zone de réception déterminée à l'avance, une répartition prédéterminée des champs magnétiques et/ou électriques entre une pluralité des éléments d'antenne.

5. Procédé suivant l'une des revendications 1 à 4, dans lequel les conditions limites sont l'une des conditions suivantes : couplage maximal autorisé ou distance mutuelle minimale entre deux éléments d'antenne, valeur limite de la puissance ou du courant pour un élément d'antenne ou valeur limite de DAS.

6. Procédé suivant l'une des revendications précédentes, dans lequel, lors du stade (S40) de réduction, la réduction des éléments d'antenne s'effectue en fonction d'une puissance à haute fréquence et/ou d'une tension électrique et/ou d'un courant électrique associé à l'élément d'antenne respectif par l'impulsion à haute fréquence.

7. Procédé suivant la revendication 6, dans lequel la dépendance vis-à-vis de la puissance à haute fréquence et/ou de la tension électrique et/ou du courant électrique est une valeur limite en dessous de laquelle il ne faut pas descendre.

8. Procédé suivant la revendication 6, dans lequel l'étape (S40) de réduction dépend d'une puissance à haute fréquence et/ou d'une tension électrique et/ou d'un courant électrique associé à un élément d'antenne voisin par l'impulsion à haute fréquence prédéterminée.

9. Procédé suivant l'une quelconque des revendications précédentes, dans lequel le critère d'arrêt est lié à un nombre maximal d'éléments d'antenne.

10. Procédé suivant la revendication 1, dans lequel le stade (S60) de mise en œuvre de la matrice d'antennes ayant des éléments d'antenne selon des positions réparties sur le volume prédéterminé comprend le stade de positionnement selon la répartition d'écarteurs entre le patient et l'élément d'antenne.
